# EUROPEAN PATENT APPLICATION

(11) **EP 4 543 181 A1**
(43) Date of publication of application: **23.04.2025**
(21) Application number: 24206885.6
(22) Date of filing: 16.10.2024
(51) Int. Cl.: H10K 59/80, H10K 102/00

(54) **DISPLAY DEVICE AND METHOD OF FABRICATING THE SAME**

(30) Priority: 18.10.2023 KR 20230139116
(71) Applicant: Samsung Display Co., Ltd., Gyeonggi-do 17113 (KR)
(72) Inventor: KIM, Jong Woo, Yongin-si, Gyeonggi-do (KR); OH, So Young, Yongin-si, Gyeonggi-do (KR); YOON, Hyun Sup, Yongin-si, Gyeonggi-do (KR); JUNG, Woo Suk, Yongin-si, Gyeonggi-do (KR); HA, Jae Heung, Yongin-si, Gyeonggi-do (KR)
(74) Representative: Gulde & Partner

(57) **Abstract**

A display device that includes a light emitting element layer disposed on a substrate, the light emitting element layer including a plurality of light emitting elements; and an encapsulation layer comprising a first inorganic encapsulation layer, an organic encapsulation layer, and a second inorganic encapsulation layer sequentially stacked on the organic encapsulation layer, the second inorganic encapsulation layer including a first inorganic layer; a second inorganic layer; and a third inorganic layer disposed on the organic encapsulation layer, a thickness of the second inorganic layer is greater than a thickness of the third inorganic layer, the thickness of the third inorganic layer is greater than a thickness of the first inorganic layer, and a refractive index of the second inorganic layer is about 1.9 or more.

## Description

### BACKGROUND

### 1. Technical Field

The disclosure relates to a display device and a method of fabricating the same.

### 2. Description of the Related Art

As the information society develops, demands for display devices for displaying images are increasing in various forms. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without a backlight that provides light to the display panel.

The display device may further include pixels that emit light, scan lines, data lines and power lines for driving the pixels, a scan driver that outputs scan signals to the scan lines, and a display driver that outputs data voltages to the data lines.

### SUMMARY

Aspects of the disclosure provide a display device including a thin encapsulation layer and a method of fabricating the display device.

However, aspects of the disclosure may not be restricted to the one set forth herein. The above and other aspects of the disclosure will become more apparent to one of ordinary skill in the art to which the disclosure pertains by referencing the detailed description of the disclosure given below.

According to an embodiment of the disclosure, a display device may comprise a light emitting element layer disposed on a substrate and comprising a plurality of light emitting elements; and an encapsulation layer comprising a first inorganic encapsulation layer disposed on the light emitting element layer, an organic encapsulation layer disposed on the first inorganic encapsulation layer, and a second inorganic encapsulation layer disposed on the organic encapsulation layer, wherein the second inorganic encapsulation layer may comprise a first inorganic layer disposed on the organic encapsulation layer; a second inorganic layer disposed on the first inorganic layer; and a third inorganic layer disposed on the second inorganic layer, a thickness of the second inorganic layer may be greater than a thickness of the third inorganic layer, the thickness of the third inorganic layer may be greater than a thickness of the first inorganic layer, and a refractive index of the second inorganic layer may be 1.9 or more, preferably 1.90 to 2.10.

A difference in refractive index between the first inorganic layer and the second inorganic layer may be less than or equal to 0.2, a difference in refractive index between the second inorganic layer and the third inorganic layer may be less than or equal to 0.2, and a difference in refractive index between the third inorganic layer and the first inorganic layer less than or equal to 0.2.

Each of the first inorganic layer, the second inorganic layer, and the third inorganic layer may comprise (or consist of) silicon nitride (SiNₓ).

A film density of the first inorganic layer may be greater than a film density of the second inorganic layer, and a film density of the third inorganic layer may be greater than the film density of the second inorganic layer.

The thickness of the second inorganic layer may be greater than a sum of the thicknesses of the first inorganic layer and the third inorganic layer.

A sum of the thicknesses of the first inorganic layer, the second inorganic layer, and the third inorganic layer may be 210 nm or less.

The thickness of the first inorganic layer may be in a range of 0.1 nm to 1.5 nm, the thickness of the second inorganic layer may be in a range of 50 nm to 150 nm, and the thickness of the third inorganic layer may be in a range of 50 nm to 100 nm.

A water vapor transmission rate (WVTR) of the second inorganic encapsulation layer may be 9*10⁻⁴g/m²day or less.

A refractive index of each of the first inorganic layer, the second inorganic layer, and the third inorganic layer may be in a range of 1.90 to 2.10.

The refractive indices of the first inorganic layer, the second inorganic layer, and the third inorganic layer may be the same.

The display device may further comprise a circuit layer disposed between the substrate and the light emitting element layer and comprising a first semiconductor layer, a first insulating layer, a first conductive layer, a second insulating layer, a second conductive layer, a third insulating layer, a second semiconductor layer, a fourth insulating layer, a third conductive layer, a fifth insulating layer and a fourth conductive layer sequentially disposed on the substrate.

According to a preferred embodiment of the disclosure, a display device may comprise a light emitting element layer disposed on a substrate and comprising a plurality of light emitting elements; and an encapsulation layer comprising a first inorganic encapsulation layer disposed on the light emitting element layer, an organic encapsulation layer disposed on the first inorganic encapsulation layer, and a second inorganic encapsulation layer disposed on the organic encapsulation layer, wherein the second inorganic encapsulation layer comprises a first inorganic layer disposed on the organic encapsulation layer; a second inorganic layer disposed on the first inorganic layer; and a third inorganic layer disposed on the second inorganic layer, a film density of the first inorganic layer may be greater than a film density of the second inorganic layer, and a refractive index of the first inorganic layer may be equal to or smaller than a refractive index of the second inorganic layer.

In this embodiment a thickness of the first inorganic layer may be in a range of 0.1 nm to 1.5 nm.

Further, preferred in this embodiment, a difference in refractive index between the first inorganic layer and the second inorganic layer may be less than or equal to 0.2, a difference in refractive index between the second inorganic layer and the third inorganic layer may be less than or equal to 0.2, and a difference in refractive index between the third inorganic layer and the first inorganic layer may be less than or equal to 0.2.

Another aspect of the disclosure relates to a method of fabricating a display device may comprise forming a light emitting element layer on a substrate, the light emitting layer may comprise a plurality of light emitting elements; forming a first inorganic encapsulation layer on the light emitting element layer; forming an organic encapsulation layer on the first inorganic encapsulation layer; and forming a second inorganic encapsulation layer on the organic encapsulation layer, wherein the forming of the second inorganic encapsulation layer may comprise forming a first inorganic layer on the organic encapsulation layer at a first deposition rate; forming a second inorganic layer on the first inorganic layer at a second deposition rate; and forming a third inorganic layer on the second inorganic layer at a third deposition rate, the second deposition rate may be greater than the first deposition rate and the third deposition rate.

The second deposition rate may be 3 nm/min or more, and the first deposition rate and the third deposition rate may be 30 nm/min or less.

The forming of the first inorganic layer, the forming of the second inorganic layer, and the forming of the third inorganic layer may be performed within the same chamber.

The forming of the first inorganic layer, the forming of the second inorganic layer, and the forming of the third inorganic layer may use the same precursor.

The precursor may comprise at least one of cyclosilazane, trisilylamine, bis(diethylamino)silane, bis(t-butylamino)silane, tris(dimethylamino)silane, tris(isopropylamino)silane, tetrakis(dimethylamino)silane, tri(isopropyl)cyclotrisilazane, tetramethyldisilazane, and a combination thereof.

The forming of the first inorganic layer may be performed by a plasma enhanced atomic layer deposition (PEALD) or plasma enhanced chemical vapor deposition (PECVD) process, and the forming of the second inorganic layer and the forming of the third inorganic layer may be performed by a PECVD process.

A display device according to an embodiment may have an inorganic encapsulation layer that may be thin, but may have excellent encapsulation characteristics.

Effects according to the embodiments may not be limited to the content exemplified above, and further various effects may be included in the specification.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view of a display device according to an embodiment;
FIG. 2 is a plan view of the display device of FIG. 1;
FIG. 3 is a schematic cross-sectional view taken in line A-A' of FIG. 2;
FIG. 4 is a schematic cross-sectional view of a subpixel of the display device according to the embodiment;
FIG. 5 is a schematic view of an encapsulation layer of the display device according to the embodiment;
FIG. 6 is an enlarged view of part B of FIG. 5;
FIG. 7 is a flowchart illustrating a method of fabricating a display device according to an embodiment;
FIG. 8 is a flowchart illustrating, in detail, a process of forming a second inorganic encapsulation layer in FIG. 7;
FIGS. 9 through 14 are views sequentially illustrating a process of fabricating a display device according to an embodiment;
FIG. 15 is a perspective view of a head mounted display device according to an embodiment;
FIG. 16 is an exploded perspective view of an example of the head mounted display device of FIG. 15; and
FIG. 17 is a perspective view of a head mounted display device according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments will be described with reference to the accompanying drawings.

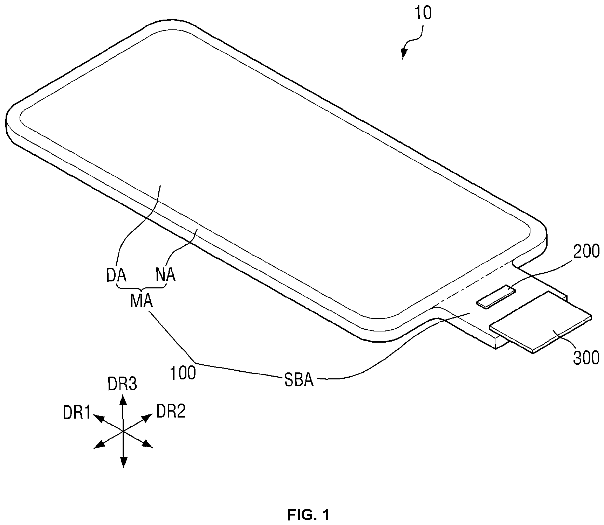

FIG. 1 is a perspective view of a display device 10 according to an embodiment.

Referring to FIG. 1, the display device 10 is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards and Internet of things (IoT) devices.

The display device 10 may be a light emitting display device such as an organic light emitting display device including an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. An embodiment in which the display device 10 is an organic light emitting display device will be described below, but the type of the display device 10 may not be limited thereto.

In an embodiment, the display device 10 may be formed approximately flat. For example, the display device 10 may be formed approximately flat on a plane defined by a first direction DR1 and a second direction DR2 and may have a thickness (or height) in a third direction DR3. In an embodiment, the display device 10 may include a curved portion in at least a part such as an edge area. The display device 10 may be formed to be flexible so that it can be bent, curved, folded, or rolled.

In an embodiment, the first direction DR1 may be a lengthwise direction, a column direction or a vertical direction of an image display surface of the display device 10, and the second direction DR2 may be a direction intersecting the first direction DR1, for example, may be a widthwise direction, a row direction or a horizontal direction. The third direction DR3 may be a thickness direction or a height direction of the display device 10.

The display device 10 may include a display panel 100, a driver 200, and a circuit board 300.

The display panel 100 may include a main area MA including a display area DA where an image is displayed and a sub-area SBA located on a side of the main area MA.

The main area MA may include the display area DA and a non-display area NA around the display area DA. The display area DA may be located in the center of the main area MA and may occupy most of the main area MA. The non-display area NA may be located at edges of the main area MA and may contact the sub-area SBA.

The display area DA may be an area where pixels may be arranged and where an image may be displayed by the pixels. In an embodiment, sensing patterns (e.g., touch electrodes) for detecting a touch input or the like may be further provided in the display area DA, and the display area DA may include a sensing area where a touch input may be detected by the sensing patterns.

In an embodiment, the display area DA may be shaped like a substantially rectangular plane having long sides in the first direction DR1 and short sides in the second direction DR2. Each corner where a long side and a short side of the display area DA meet may be rounded or right-angled. The shape of the display area DA may vary according to embodiments. For example, the display area DA may also have a polygonal shape other than a quadrilateral shape, a circular shape, or an oval shape.

The non-display area NA may be located immediately around the display area DA. The non-display area NA may surround the display area DA. An embedded circuit may be disposed in the non-display area NA. For example, an embedded circuit such as a scan driving circuit may be disposed in the non-display area NA on a side (e.g., a left or right side) or both sides of the display area DA.

The sub-area SBA may be located on a side of the main area MA. For example, the sub-area SBA may be an area protruding from a side of the main area MA in the first direction DR1. For example, the sub-area SBA may protrude from a lower end of the main area MA in the first direction DR1. In an embodiment, the sub-area SBA may be narrower than the main area MA. For example, the sub-area SBA may be narrower than the main area MA in the second direction DR2.

Lines and pads may be disposed in the sub-area SBA. For example, lines and pads electrically connected to pixels and/or an embedded circuit located in the main area MA and the driver 200 and/or the circuit board 300 located in the sub-area SBA may be disposed in the sub-area SBA. In the description of embodiments, the term "connection" may mean electrical connection and/or physical connection.

In an embodiment, the driver 200 (e.g., a display driving circuit) may be mounted in the sub-area SBA. The circuit board 300 may be disposed on a portion of the sub-area SBA.

The driver 200 may include a data driving circuit for driving pixels. In an embodiment, the driver 200 may be formed as an integrated circuit (IC) and disposed in the sub-area SBA. In an embodiment, the driver 200 may be disposed on the circuit board 300 in the sub-area SBA or may be disposed on another circuit board electrically connected to the display panel 100 through the circuit board 300.

The circuit board 300 may be disposed on a portion of the sub-area SBA. For example, the circuit board 300 may be bonded onto pads located in a portion (e.g., a lower edge) of the sub-area SBA and may supply or transmit power voltages and driving signals for driving the display panel 100 to the display panel 100. For example, the circuit board 300 may supply input image data (e.g., digital image data), driving signals including timing signals, and driving voltages to the display panel 100. The circuit board 300 may be, but may not be limited to, a flexible printed circuit board (FPCB), a printed circuit board (PCB), or a flexible film such as a chip on film (COF).

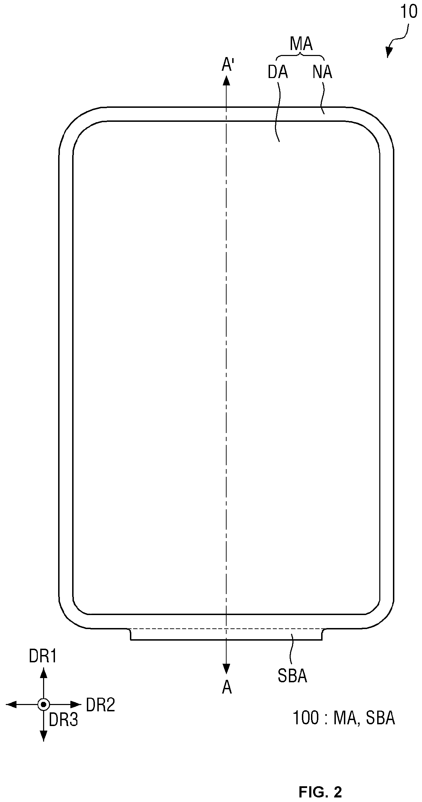

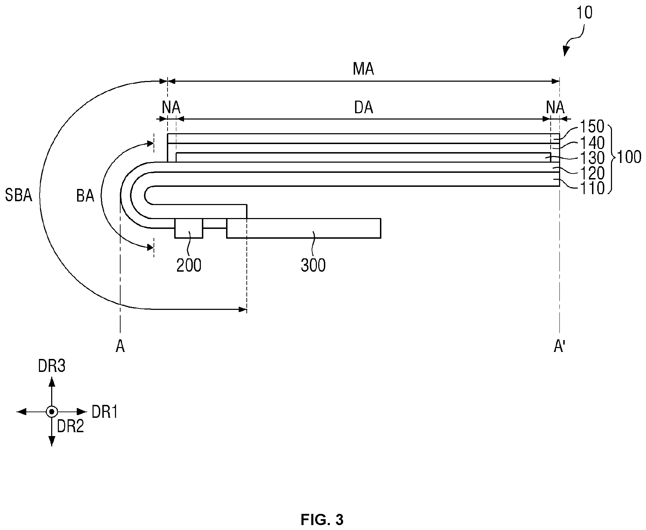

FIG. 2 is a plan view of the display device 10 of FIG. 1. FIG. 3 is a schematic cross-sectional view taken along line A-A' of FIG. 2.

FIG. 1 illustrates a state in which the display device 10 is unfolded without being bent, and FIGS. 2 and 3 illustrate a state in which the display device 10 is bent in the sub-area SBA. FIG. 1 illustrates a state in which the sub-area SBA is unfolded to lie side by side with the main area MA, and FIGS. 2 and 3 illustrate a state in which a portion of the sub-area SBA is bent.

Referring to FIGS. 2 and 3, the display panel 100 may include a substrate 110 including the main area MA and the sub-area SBA and a circuit layer 120, a light emitting element layer 130, an encapsulation layer 140 and a color filter layer 150 sequentially disposed on the substrate 110. The circuit layer 120 may be located on the substrate 110 in the main area MA and the sub-area SBA. The light emitting element layer 130, the encapsulation layer 140, and the color filter layer 150 may be located on a portion of the substrate 110 and the circuit layer 120. For example, the light emitting element layer 130, the encapsulation layer 140, and the color filter layer 150 may be located in the main area MA.

In an embodiment, the display device 10 may further include an additional element disposed on the display panel 100. For example, the display device 10 may further include at least one of a sensor layer (e.g., a touch sensor layer), a polarizing layer, and a protective layer (e.g., a window) disposed on the encapsulation layer 140. Each of the sensor layer, the polarizing layer, and/or the protective layer may be manufactured integrally with the display panel 100 or may be manufactured separately from the display panel 100 and then attached to the display panel 100 by an adhesive layer or the like.

The main area MA may include the display area DA and the non-display area NA. The non-display area NA may be located around the display area DA. For example, the non-display area NA may be an edge area of the main area MA located outside the display area DA.

The substrate 110 may include an insulating material such as polymer resin. For example, the substrate 110 may be made of polyimide or other insulating materials. The substrate 110 may be a flexible substrate that can be bent, folded, or rolled. As another example, the substrate 110 may include an insulating material such as glass.

The circuit layer 120 may include pixel circuits and lines. For example, the circuit layer 120 may include circuit elements (e.g., pixel transistors and a capacitor) constituting a pixel circuit of each pixel and lines electrically connected to the pixels. In an embodiment, the circuit layer 120 may further include circuit elements constituting an embedded circuit, such as a scan driving circuit, and lines electrically connected to the embedded circuit.

The light emitting element layer 130 may include light emitting elements disposed in emission areas of pixels. For example, each of the pixels may include at least one light emitting element and a pixel circuit electrically connected to the light emitting element. Each of the pixels may be located in a pixel area including an emission area where a light emitting element may be disposed and a pixel circuit area where a pixel circuit may be disposed. The emission area and pixel circuit area of each pixel may overlap each other, but the disclosure may not be limited thereto.

In the description of embodiments, the circuit layer 120 and the light emitting element layer 130 may be described as being separate from each other. However, the embodiments may not be limited thereto. For example, the circuit layer 120 and the light emitting element layer 130 may also be integrated.

The encapsulation layer 140 may cover the light emitting element layer 130 and extend to the non-display area NA to contact the circuit layer 120. In an embodiment, the encapsulation layer 140 may have a multilayer structure including at least two inorganic encapsulation layers overlapping each other and at least one organic encapsulation layer disposed between the inorganic encapsulation layers.

In an embodiment, the display panel 100 may be bent in a bending area BA. The bending area BA may be a portion of the sub-area SBA and may be spaced apart from the main area MA.

The substrate 110 and the circuit layer 120 may be bent in the bending area BA corresponding to a portion of the sub-area SBA. Accordingly, a bezel area perceived by a user as the non-display area NA can be reduced or minimized.

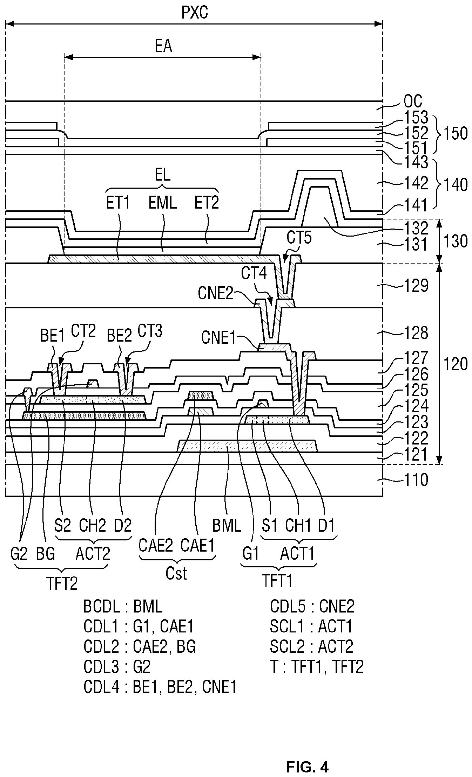

FIG. 4 is a schematic cross-sectional view of a subpixel of the display device 10 according to the embodiment. FIG. 4 is a schematic cross-sectional view of a portion of an area corresponding to a subpixel of the display area DA.

Referring to FIG. 4, the display panel 100 may include the substrate 110 and the circuit layer 120, the light emitting element layer 130, the encapsulation layer 140 and the color filter layer 150 disposed on the substrate 110. The circuit layer 120, the light emitting element layer 130, the encapsulation layer 140, and the color filter layer 150 may be sequentially disposed or stacked on each other on the substrate 110 in the third direction DR3.

The substrate 110 may be made of a flexible material that can be bent, folded, or rolled. The substrate 110 may be made of an insulating material such as polymer resin. For example, the substrate 110 may be made of polyimide.

The circuit layer 120 may include pixel circuits PXC and lines. For example, the circuit layer 120 may include circuit elements (e.g., pixel transistors T and a capacitor Cst) constituting the pixel circuit PXC of each subpixel and lines (e.g., various power lines and signal lines including power lines, scan lines, emission control lines, and data lines) electrically connected to the subpixels.

FIG. 4 illustrates a first thin-film transistor TFT1 (also referred to as a "first pixel transistor"), a second thin-film transistor TFT2 (also referred to as a "second pixel transistor"), and a capacitor Cst included in the pixel circuit PXC of each subpixel among the elements that can be provided in the circuit layer 120. The first thin-film transistor TFT1 may represent first-type transistors (e.g., P-type transistors) including a first semiconductor material (e.g., polysilicon) among the pixel transistors T constituting each pixel circuit PXC. In FIG. 4, a transistor electrically connected to a light emitting element EL through at least one connection electrode (e.g., a first connection electrode CNE1 and a second connection electrode CNE2) among the first-type transistors may be illustrated as an example of the first thin-film transistor TFT1. The second thin-film transistor TFT2 may represent second-type transistors (e.g., N-type transistors) including a second semiconductor material (e.g., an oxide semiconductor) among the pixel transistors T.

The cross-sections of the subpixels may vary according to the type and/or structure of each subpixel and the display panel 100 including the subpixels. For example, the positions and formation order of the first thin-film transistor TFT1, the second thin-film transistor TFT2, and the capacitor Cst may vary according to embodiments.

The circuit layer 120 may include semiconductor layers, conductive layers for forming circuit elements and lines, and insulating layers disposed between and/or around the conductive layers and the semiconductor layers. For example, the circuit layer 120 may include a first semiconductor layer SCL1 (e.g., a polysilicon semiconductor layer), a first insulating layer 123 (e.g., a first gate insulating layer), a first conductive layer CDL1 (e.g., a first gate conductive layer), a second insulating layer 124 (e.g., a second gate insulating layer), a second conductive layer CDL2 (e.g., a second gate conductive layer), a third insulating layer 125 (e.g., a first interlayer insulating layer), a second semiconductor layer SCL2 (e.g., an oxide semiconductor layer), a fourth insulating layer 126 (e.g., a third gate insulating layer), a third conductive layer CDL3 (e.g., a third gate conductive layer), a fifth insulating layer 127 (e.g., a second interlayer insulating layer), a fourth conductive layer CDL4 (e.g., a first source-drain conductive layer), and a sixth insulating layer 128 (e.g., a first via layer or a first planarization layer) sequentially disposed on the substrate 110 in the third direction DR3. In an embodiment, the circuit layer 120 may further include a fifth conductive layer CDL5 (e.g., a second source-drain conductive layer) and a seventh insulating layer 129 (e.g., a second via layer or a second planarization layer) sequentially disposed on the sixth insulating layer 128. In an embodiment, the circuit layer 120 may further include a bottom conductive layer BCDL disposed between the substrate 110 and the first semiconductor layer SCL1, a barrier layer 121 disposed between the substrate 110 and the bottom conductive layer BCDL, and a buffer layer 122 disposed between the bottom conductive layer BCDL and the first semiconductor layer SCL1.

The barrier layer 121 may be disposed on the substrate 110. The barrier layer 121 may protect elements disposed in the circuit layer 120 and the light emitting element layer 130 from moisture introduced through the substrate 110 which may be vulnerable to moisture penetration. The barrier layer 121 may include at least one inorganic layer including an inorganic insulating material (e.g., silicon nitride, silicon oxide, silicon oxynitride, titanium oxide, aluminum oxide, other inorganic insulating materials, or a combination thereof). The material of the barrier layer 121 may vary according to embodiments.

The bottom conductive layer BCDL may be disposed on the barrier layer 121. The bottom conductive layer BCDL may include a bottom metal layer BML overlapped by an active layer (e.g., a first active layer ACT1 and/or a second active layer ACT2) of at least one pixel transistor T and/or at least one line (or a portion of the at least one line). In FIG. 4, the bottom metal layer BML may be overlapped by only the first active layer ACT1 of the first thin-film transistor TFT1 and capacitor electrodes CAE1 and CAE2 of the capacitor Cst, but the disclosure may be limited thereto. For example, the bottom metal layer BML may also be patterned into an appropriate size and/or shape as needed and may be disposed in a portion of the pixel circuit PXC or may be disposed in the entire pixel circuit PXC. In an embodiment, the bottom metal layer BML may be used as a light blocking pattern and/or a back-gate electrode of at least one pixel transistor T.

The buffer layer 122 may be disposed on the bottom conductive layer BCDL to cover the bottom conductive layer BCDL. The buffer layer 122 may include at least one inorganic layer including an inorganic insulating material.

The first thin-film transistor TFT1, the second thin-film transistor TFT2, and the capacitor Cst may be disposed on a surface of the substrate 110 including the buffer layer 122. The first thin-film transistor TFT1 may include the first active layer ACT1 and a first gate electrode G1. The second thin-film transistor TFT2 may include the second active layer ACT2 and second gate electrodes G2. In an embodiment, the second thin-film transistor TFT2 may include a back-gate electrode BG. The capacitor Cst may include a first capacitor electrode CAE1 and a second capacitor electrode CAE2.

The first semiconductor layer SCL1 may be disposed on the buffer layer 122. The first semiconductor layer SCL1 may include the first active layer ACT1 of the first thin-film transistor TFT1.

The first active layer ACT1 may be provided in the first semiconductor layer SCL1 and may include a first semiconductor material (e.g., polysilicon). The first active layer ACT1 may include a first channel region CH1, a first source region S1, and a first drain region D1. The first channel region CH1 may be overlapped by the first gate electrode G1 in the third direction DR3. The first source region S1 may be disposed on a side of the first channel region CH1, and the first drain region D1 may be disposed on another side of the first channel region CH1. The first source region S1 and the first drain region D1 may be regions formed to have conductivity by doping a semiconductor for forming the first active layer ACT1 with ions or impurities. In an embodiment, the first source region S1 may be a source electrode of the first thin-film transistor TFT1. In an embodiment, the first thin-film transistor TFT1 may include a separate source electrode electrically connected to the first source region S1. In an embodiment, the first drain region D1 may be a drain electrode of the first thin-film transistor TFT1. In an embodiment, the first thin-film transistor TFT1 may include a separate drain electrode electrically connected to the first drain region D1.

The first insulating layer 123 may be disposed on the first semiconductor layer SCL1. The first insulating layer 123 may cover the first semiconductor layer SCL1.

The first conductive layer CDL1 may be disposed on the first insulating layer 123. The first conductive layer CDL1 may include the first gate electrode G1 of the first thin-film transistor TFT1. The first gate electrode G1 may overlap a portion (e.g., the first channel region CH1) of the first active layer ACT1. In an embodiment, the first conductive layer CDL1 may further include at least one line (or a portion of the at least one line), a metal pattern (e.g., a bridge pattern), and/or a capacitor electrode. For example, the first conductive layer CDL1 may further include the first capacitor electrode CAE1 of the capacitor Cst.

In an embodiment, the first capacitor electrode CAE1 may be formed integrally with the gate electrode of at least one first thin-film transistor TFT1. For example, the first capacitor electrode CAE1 and the gate electrode of the first thin-film transistor TFT1 may be formed as one conductive pattern, and the second capacitor electrode CAE2 may be disposed to overlap the conductive pattern.

The second insulating layer 124 may be disposed on the first conductive layer CDL1. The second insulating layer 124 may cover the first conductive layer CDL1.

The second conductive layer CDL2 may be disposed on the second insulating layer 124. The second conductive layer CDL2 may include one electrode of the capacitor Cst, for example, the second capacitor electrode CAE2. In an embodiment, the second conductive layer CDL2 may further include at least one electrode, at least one line (or a portion of the at least one line), and/or a metal pattern (e.g., a bridge pattern). For example, the second conductive layer CDL2 may further include the back-gate electrode BG electrically connected to a second gate electrode G2 of the second thin-film transistor TFT2.

The third insulating layer 125 may be disposed on the second conductive layer CDL2. The third insulating layer 125 may cover the second conductive layer CDL2.

The second semiconductor layer SCL2 may be disposed on the third insulating layer 125. The second semiconductor layer SCL2 may include the second active layer ACT2 of the second thin-film transistor TFT2.

The second active layer ACT2 may be provided in the second semiconductor layer SCL2 and may include a second semiconductor material (e.g., an oxide semiconductor) different from the first semiconductor material. For example, the second active layer ACT2 may include IGZO (indium (In), gallium (Ga), zinc (Zn), and oxygen (O)), IGZTO (indium (In), gallium (Ga), zinc (Zn), tin (Sn), and oxygen (O)), or IGTO (indium (In), gallium (Ga), tin (Sn), and oxygen (O)).

The second active layer ACT2 may include a second channel region CH2, a second source region S2, and a second drain region D2. The second channel region CH2 may be overlapped by a second gate electrode G2 in the third direction DR3. The second source region S2 may be disposed on a side of the second channel region CH2, and the second drain region D2 may be disposed on another side of the second channel region CH2. The second source region S2 and the second drain region D2 may be regions formed to have conductivity by doping a semiconductor for forming the second active layer ACT2 with ions or impurities. In an embodiment, the second source region S2 may be a source electrode of the second thin-film transistor TFT2. In an embodiment, the second thin-film transistor TFT2 may include a separate source electrode electrically connected to the second source region S2. In an embodiment, the second drain region D2 may be a drain electrode of the second thin-film transistor TFT2. In an embodiment, the second thin-film transistor TFT2 may include a separate drain electrode electrically connected to the second drain region D2.

The fourth insulating layer 126 may be disposed on the second semiconductor layer SCL2. The fourth insulating layer 126 may cover the second semiconductor layer SCL2.

The third conductive layer CDL3 may be disposed on the fourth insulating layer 126. The third conductive layer CDL3 may include the second gate electrodes G2 of the second thin-film transistor TFT2. One of the second gate electrodes G2 may overlap a portion (e.g., the second channel region CH2) of the second active layer ACT2. In an embodiment, the third conductive layer CDL3 may further include at least one line (or a portion of the at least one line), a metal pattern (e.g., a bridge pattern), and/or a capacitor electrode.

In an embodiment, each of the electrodes, the conductive patterns, and/or the lines provided in the bottom conductive layer BCDL, the first conductive layer CDL1, the second conductive layer CDL2, and the third conductive layer CLD3 may include a conductive material (e.g., at least one of molybdenum (Mo), aluminum (Al), chromium (Cr), gold (Au), titanium (Ti), nickel (Ni), neodymium (Nd), copper (Cu), other metals, an alloy thereof, other conductive materials, or a combination thereof) and may have a single-layer or multilayer structure. For example, each of the electrodes, the conductive patterns, and/or the lines provided in the bottom conductive layer BCDL, the first conductive layer CDL1, the second conductive layer CDL2, and the third conductive layer CLD3 may include molybdenum (Mo) or other metal materials. At least two of the bottom conductive layer BCDL, the first conductive layer CDL1, the second conductive layer CDL2, and the third conductive layer CLD3 may include a same material or different materials. The material of each of the bottom conductive layer BCDL, the first conductive layer CDL1, the second conductive layer CDL2, and the third conductive layer CLD3 may not be limited and may vary according to embodiments.

The fifth insulating layer 127 may be disposed on the third conductive layer CDL3. The fifth insulating layer 127 may cover the third conductive layer CDL3.

In an embodiment, each of the first insulating layer 123, the second insulating layer 124, the third insulating layer 125, the fourth insulating layer 126, and the fifth insulating layer 127 may be an inorganic insulating layer including an inorganic insulating material (e.g., silicon nitride, silicon oxide, silicon oxynitride, titanium oxide, aluminum oxide, other inorganic insulating materials, or a combination thereof) and may have a single-layer or multilayer structure. At least two of the first insulating layer 123, the second insulating layer 124, the third insulating layer 125, the fourth insulating layer 126, and the fifth insulating layer 127 may include a same material or different materials. The material of each of the first insulating layer 123, the second insulating layer 124, the third insulating layer 125, the fourth insulating layer 126, and the fifth insulating layer 127 may vary according to embodiments.

The fourth conductive layer CDL4 may be disposed on the fifth insulating layer 127. The fourth conductive layer CDL4 may include the first connection electrode CNE1 (or the drain electrode of the first thin-film transistor TFT1), a first bridge electrode BE1 (or the source electrode of the second thin-film transistor TFT2), and a second bridge electrode BE2 (or the drain electrode of the second thin-film transistor TFT2). The first connection electrode CNE1 may be provided in the fourth conductive layer CDL4 and electrically connected to the first drain region D1 of the first active layer ACT1 through a first contact hole CT1 penetrating the first insulating layer 123, the second insulating layer 124, the third insulating layer 125, the fourth insulating layer 126, and the fifth insulating layer 127. The first bridge electrode BE1 may be provided in the fourth conductive layer CDL4 and electrically connected to the second source region S2 of the second active layer ACT2 through a second contact hole CT2 penetrating the fourth insulating layer 126 and the fifth insulating layer 127. The second bridge electrode BE2 may be electrically connected to the second drain region D2 of the second active layer ACT2 through a third contact hole CT3 penetrating the fourth insulating layer 126 and the fifth insulating layer 127. In an embodiment, the fourth conductive layer CDL4 may further include at least one line (or a portion of the at least one line) and/or a metal pattern (e.g., a bridge pattern). For example, the fourth conductive layer CDL4 may include a portion of a power line (e.g., a first pixel power line and/or a second pixel power line) provided inside and/or outside the display area DA.

The sixth insulating layer 128 may be disposed on the fourth conductive layer CDL4. The sixth insulating layer 128 may cover the fourth conductive layer CDL4.

The fifth conductive layer CDL5 may be disposed on the sixth insulating layer 128. The fifth conductive layer CDL5 may include the second connection electrode CNE2. The second connection electrode CNE2 may be provided in the fifth conductive layer CDL5 and electrically connected to the first connection electrode CNE1 through a fourth contact hole CT4 (or a first via hole) penetrating the sixth insulating layer 128. In an embodiment, the fifth conductive layer CDL5 may further include at least one line (or a portion of the at least one line) and/or a metal pattern (e.g., a bridge pattern). For example, the fifth conductive layer CDL5 may include a portion of a power line (e.g., the first pixel power line and/or the second pixel power line) provided inside and/or outside the display area DA.

In an embodiment, each of the electrodes, the conductive patterns, and/or the lines provided in the fourth conductive layer CDL4 and the fifth conductive layer CDL5 may include a conductive material (e.g., at least one of molybdenum (Mo), aluminum (Al), chromium (Cr), gold (Au), titanium (Ti), nickel (Ni), neodymium (Nd), copper (Cu) and other metals, an alloy thereof, or other conductive materials) and may have a single-layer or multilayer structure. For example, each of the electrodes, the conductive patterns, and/or the lines provided in the fourth conductive layer CDL4 and the fifth conductive layer CDL5 may have a triple-layer structure of titanium/aluminum/titanium (Ti/AI/Ti). The fourth conductive layer CDL4 and the fifth conductive layer CDL5 may include a same material or different materials. The material of each of the fourth conductive layer CDL4 and the fifth conductive layer CDL5 may vary according to embodiments.

The seventh insulating layer 129 may be disposed on the fifth conductive layer CDL5. The seventh insulating layer 129 may cover the fifth conductive layer CDL5.

In an embodiment, each of the sixth insulating layer 128 and the seventh insulating layer 129 may be an organic insulating layer including an organic insulating material (e.g., acryl resin, epoxy resin, phenolic resin, polyamide resin, polyimide resin, other organic insulating materials, or a combination thereof) to planarize the circuit layer 120 and may have a single-layer or multilayer structure. The sixth insulating layer 128 and the seventh insulating layer 129 may include a same material or different materials. The material of each of the sixth insulating layer 128 and the seventh insulating layer 129 may vary according to embodiments.

The light emitting element layer 130 may include a pixel defining layer 131 defining emission areas EA of the pixels and light emitting elements EL respectively located in the emission areas EA. In an embodiment, the light emitting element layer 130 may further include a spacer 132 disposed on a portion of the pixel defining layer 131.

Each light emitting element EL may include a first electrode ET1 (e.g., an anode) electrically connected to at least one transistor T (e.g., the first thin-film transistor TFT1) included in a corresponding subpixel through the first connection electrode CNE1 and/or the second connection electrode CNE2, a light emitting layer EML, and a second electrode ET2 (e.g., a cathode) sequentially disposed on the first electrode ET1. In an embodiment, each light emitting element EL may further include a first intermediate layer (e.g., a hole layer including a hole transport layer) disposed between the first electrode ET1 and the light emitting layer EML and a second intermediate layer (e.g., an electron layer including an electron transport layer) disposed between the light emitting layer EML and the second electrode ET2.

The first electrode ET1 of each light emitting element EL may include a conductive material and may be disposed on the circuit layer 120. For example, the first electrode ET1 may be disposed on the seventh insulating layer 129 in each emission area EA. The first electrode ET1 may be electrically connected to the second connection electrode CNE2 through a fifth contact hole CT5 (or a second via hole) penetrating the seventh insulating layer 129.

In an embodiment, the first electrode ET1 may include a metal material having high reflectivity or a transparent conductive metal oxide. For example, the first electrode ET1 may have a single-layer structure of molybdenum (Mo), titanium (Ti), copper (Cu), aluminum (Al), or a combination thereof, or may have a multilayer structure (e.g., ITO/Mg, ITO/MgF, ITO/Ag, or ITO/Ag/ITO) including indium-tin-oxide (ITO), indium-zinc-oxide (IZO), zinc oxide (ZnO) or indium oxide (In₂O₃) and silver (Ag), magnesium (Mg), aluminum (Al), platinum (Pt), lead (Pb), gold (Au), nickel (Ni), or a combination thereof.

The light emitting layer EML of each light emitting element EL may include a high molecular material or a low molecular material. In an embodiment, the light emitting layer EML may be disposed for each subpixel, and the light emitting layer EML of each subpixel may emit visible light of a color corresponding to the subpixel. In an embodiment, the light emitting layer EML may be a common layer shared by subpixels of different colors, and a wavelength conversion layer and/or a color filter corresponding to a color (or wavelength band) of light to be emitted from each subpixel may be disposed in the emission areas EA of at least some of the subpixels.

The second electrode ET2 of each light emitting element EL may include a conductive material and may be electrically connected to the second pixel power line. In an embodiment, the second electrode ET2 may be a common layer formed over the entire display area DA to cover the light emitting layers EML and the pixel defining layer 131. In an embodiment, the second electrode ET2 may be made of a transparent conductive material (TCO) that can transmit light, such as ITO or IZO, or a semi-transmissive conductive material such as magnesium (Mg), silver (Ag) or an alloy of Mg and Ag. In case that the second electrode ET2 is made of a semi-transmissive conductive material, an improvement in light output efficiency by a microcavity effect can be expected.

The pixel defining layer 131 may have openings corresponding to the emission areas EA, respectively, and may surround the emission areas EA. For example, the pixel defining layer 131 may be formed to cover edges of the first electrode ET1 of each light emitting element EL and may include an opening exposing another portion of the first electrode ET1. An area where the exposed first electrode ET1 and the light emitting layer EML overlap (or an area including them) may be defined as the emission area EA of each pixel PX or each subpixel.

In an embodiment, the pixel defining layer 131 may include at least one organic layer including an organic insulating material. For example, the pixel defining layer 131 may include polyacrylate resin, epoxy resin, phenolic resin, polyamide resin, polyimide resin, unsaturated polyester resin, polyphenylene resin, polyphenylene sulfide resin, benzocyclobutene (BCB), other organic insulating materials, or a combination thereof.

The spacer 132 may be disposed on a portion of the pixel defining layer 131. The spacer 132 may include at least one organic layer including an organic insulating material. The spacer 132 may include a same material as the pixel defining layer 131 or may include a different material from the pixel defining layer 131. In an embodiment, the pixel defining layer 131 and the spacer 132 may be sequentially formed through respective mask processes. In an embodiment, the pixel defining layer 131 and the spacer 132 may be simultaneously formed using a halftone mask. The pixel defining layer 131 and the spacer 132 may be considered as one integrated insulating layer. The organic insulating material that forms the spacer 132 may not be particularly limited and may vary according to embodiments.

The encapsulation layer 140 may be disposed on the light emitting element layer 130 in the main area MA. For example, the encapsulation layer 140 may be disposed in the display area DA and the non-display area NA to cover the light emitting element layer 130. The encapsulation layer 140 may block penetration of oxygen or moisture into the light emitting element layer 130 and reduce electrical or physical shock to the circuit layer 120 and the light emitting element layer 130.

In an embodiment, the encapsulation layer 140 may include a first inorganic encapsulation layer 141, an organic encapsulation layer 142, and a second inorganic encapsulation layer 143 sequentially disposed on the light emitting element layer 130. The first inorganic encapsulation layer 141 and the second inorganic encapsulation layer 143 may include an inorganic insulating material, and the organic encapsulation layer 142 may include an organic material. Examples of the inorganic insulating material included in each of the first inorganic encapsulation layer 141 and the second inorganic encapsulation layer 143 may include, but may not be limited to, aluminum oxide, titanium oxide, tantalum oxide, hafnium oxide, zinc oxide, silicon oxide, silicon nitride, and/or silicon oxynitride. Examples of the organic material included in the organic encapsulation layer 142 may include, but may not be limited to, polymers such as acrylic resin, epoxy resin, polyimide, polyethylene, or a combination thereof.

Although an embodiment of the encapsulation layer 140 in which the organic encapsulation layer 142 may be disposed between two different inorganic encapsulation layers 141 and 143 has been described, the disclosure may not be limited thereto. In some embodiments, the organic encapsulation layer 142 may be omitted, and the encapsulation layer 140 may have a structure in which one or more inorganic encapsulation layers may be stacked on each other.

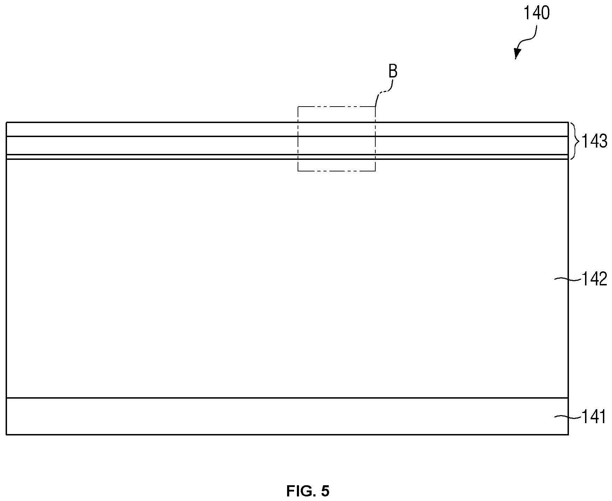

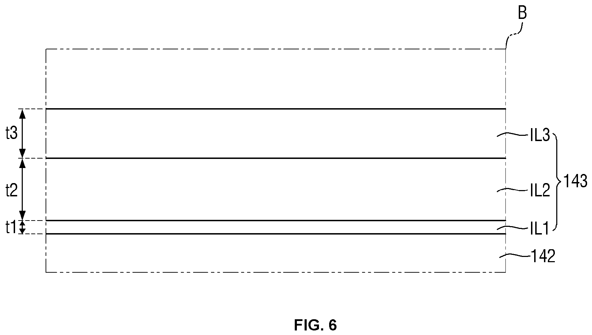

FIG. 5 is a schematic view of the encapsulation layer 140 of the display device 10 according to the embodiment. FIG. 6 is an enlarged view of part B of FIG. 5.

Referring to FIGS. 5 and 6, in the display device 10, the second inorganic encapsulation layer 143 of the encapsulation layer 140 may have a structure in which one or more inorganic insulating layers may be stacked on each other. Although the second inorganic encapsulation layer 143 has a structure in which multiple layers may be stacked on each other, it may be relatively thin. In the display device 10, the second inorganic encapsulation layer 143 including multiple inorganic insulating layers may have a thin thickness and serve to encapsulate the display panel 100.

The second inorganic encapsulation layer 143 may include a first inorganic layer IL1 disposed on the organic encapsulation layer 142, a second inorganic layer IL2 disposed on the first inorganic layer IL1, and a third inorganic layer IL3 disposed on the second inorganic layer IL2. A lower surface of the first inorganic layer IL1 may contact the organic encapsulation layer 142, and an upper surface of the first inorganic layer IL1 may contact the second inorganic layer IL2. A lower surface of the second inorganic layer IL2 may contact the first inorganic layer IL1, and an upper surface of the second inorganic layer IL2 may contact the third inorganic layer IL3. A lower surface of the third inorganic layer IL3 may contact the second inorganic layer IL2. An upper surface of the third inorganic layer IL3 may contact a sensor layer or the color filter layer 150.

According to an embodiment, the first inorganic layer IL1, the second inorganic layer IL2, and the third inorganic layer IL3 may include a same material, but may be different in some physical properties or nature. The first inorganic layer IL1, the second inorganic layer IL2, and the third inorganic layer IL3 may be formed under different fabrication processes or conditions, and accordingly, some of their physical properties may be different from each other.

For example, the first inorganic layer IL1, the second inorganic layer IL2, and the third inorganic layer IL3 may each include or consist of silicon nitride (SiNₓ). The first inorganic layer IL1 may be formed through a plasma enhanced chemical vapor deposition (PECVD) process or a plasma enhanced atomic layer deposition (PEALD) process, and the second inorganic layer IL2 and the third inorganic layer IL3 may be formed through a PECVD process. PECVD process conditions (e.g., deposition rates) of the second inorganic layer IL2 and the third inorganic layer IL3 may be different from each other.

The first inorganic layer IL1 may have a relatively high density and a small thickness t1. The film density of the first inorganic layer IL1 may be greater than the film density of the second inorganic layer IL2. The thickness t1 of the first inorganic layer IL1 may be significantly smaller than a thickness t2 of the second inorganic layer IL2 and a thickness t3 of the third inorganic layer IL3. In an embodiment, the thickness t1 of the first inorganic layer IL1 may be in a range of about 0.1 nm to about 1.5 nm. In the above range, the high-density first inorganic layer IL1 can be formed within a short tact time.

The second inorganic layer IL2 may have a relatively low density and a large thickness t2. The film density of the second inorganic layer IL2 may be smaller than the film density of the first inorganic layer IL1 and the film density of the third inorganic layer IL3. The thickness t2 of the second inorganic layer IL2 may be significantly greater than the thickness t1 of the first inorganic layer IL1 and the thickness t3 of the third inorganic layer IL3. The thickness t2 of the second inorganic layer IL2 may be greater than the sum of the thickness t1 of the first inorganic layer IL1 and the thickness t3 of the third inorganic layer IL3. In an embodiment, the thickness t2 of the second inorganic layer IL2 may be in a range of about 50 nm to about 150 nm. In an embodiment, the thickness t2 of the second inorganic layer IL2 may be in a range of about 100 nm to about 150 nm. In the above range, the low-density second inorganic layer IL2 can have an excellent planarization function.

The film density of the third inorganic layer IL3 may be greater than the film density of the second inorganic layer IL2 and similar to the film density of the first inorganic layer IL1. The thickness t3 of the third inorganic layer IL3 may be greater than the thickness t1 of the first inorganic layer IL1 and smaller than the thickness t2 of the second inorganic layer IL2. In an embodiment, the thickness t3 of the third inorganic layer IL3 may be in a range of about 50 nm to about 100 nm. In the above range, the third inorganic layer IL3 can have sufficient encapsulation properties while having a thin thickness.

The thickness of the second inorganic encapsulation layer 143 may be about 210 nm or less. In an embodiment, the sum (t1+t2+t3) of the thicknesses of the first inorganic layer IL1, the second inorganic layer IL2, and the third inorganic layer IL3 may be about 210 nm or less. In an embodiment, the sum (t1+t2+t3) of the thicknesses of the first inorganic layer IL1, the second inorganic layer IL2, and the third inorganic layer IL3 may be about 130 nm or more. In an embodiment, the sum (t1+t2+t3) of the thicknesses of the first inorganic layer IL1, the second inorganic layer IL2, and the third inorganic layer IL3 may be in a range of about 150 nm to about 201 nm. The total thickness of the second inorganic encapsulation layer 143 and the total thickness of the encapsulation layer 140 may be reduced. Furthermore, the total thickness of the first inorganic layer IL1, the second inorganic layer IL2 and the third inorganic layer IL3 and the thickness ratio of the layers having different thicknesses may be adjusted within the above range. Therefore, even if the second inorganic encapsulation layer 143 has a thin thickness, it can have sufficient encapsulation properties.

A refractive index of each of the first inorganic layer IL1, the second inorganic layer IL2, and the third inorganic layer IL3 may be in a range of about 1.90 to about 2.10. The refractive indices of the first inorganic layer IL1, the second inorganic layer IL2, and the third inorganic layer IL3 may be the same or different from each other.

The refractive indices of the first inorganic layer IL1, the second inorganic layer IL2, and the third inorganic layer IL3 may be the same or similar to each other. In an embodiment, a difference in refractive index between the first inorganic layer IL1 and the second inorganic layer IL2 may be less than or equal to about 0.2, a difference in refractive index between the second inorganic layer IL2 and the third inorganic layer IL3 may be less than or equal to about 0.2, and a difference in refractive index between the third inorganic layer IL3 and the first inorganic layer IL1 may be less than or equal to about 0.2. The difference in refractive index between the first inorganic layer IL1 and the second inorganic layer IL2 may not exceed about 0.2, the difference in refractive index between the second inorganic layer IL2 and the third inorganic layer IL3 may not exceed about 0.2, and the difference in refractive index between the third inorganic layer IL3 and the first inorganic layer IL1 may not exceed about 0.2. In an embodiment, each of the first inorganic layer IL1, the second inorganic layer IL2, and the third inorganic layer IL3 may be different in refractive index from an adjacent inorganic layer by less than about 0.1. The difference in refractive index between each of the first inorganic layer IL1, the second inorganic layer IL2 and the third inorganic layer IL3 and an adjacent inorganic layer may not exceed about 0.1. In an embodiment, the refractive indices of the first inorganic layer IL1, the second inorganic layer IL2, and the third inorganic layer IL3 may be the same. In case that the refractive indices of the first inorganic layer IL1, the second inorganic layer IL2, and the third inorganic layer IL3 may be the same or similar to each other, light reflection at the interface between the layers can be reduced, and light efficiency can be increased.

The second inorganic layer IL2 may have a relatively low film density but a refractive index of about 1.9 or more, preferably 1.90 to 2.10. In an embodiment, the refractive index of the first inorganic layer IL1 may be equal to or smaller than the refractive index of the second inorganic layer IL2.

In the specification, film density and thickness may be measured using an Xray reflectometry (XRR) (Bruker's D8 ADVANCE Plus) device. In the specification, refractive index may be measured using an optical measuring instrument such as an ellipsometer or a spectral reflectometer. The ellipsometer may measure refractive index by measuring a change in polarization of light incident on and reflected from an inorganic layer to calculate the thickness and complex refractive index of the inorganic layer. The spectral reflectometer may measure the refractive index of an inorganic layer by comparing the intensity of light obtained by changing the wavelength. The refractive index may be a value measured at room temperature (21°C) and atmospheric pressure. The refractive index may be a value measured at yellow spectral line of helium (587.56 nm) or at a green spectral line of mercury (546.07 nm). Preferably, the refractive index may be measured by ellipsometry at a wavelength of 587.56 nm, at room temperature (21°C) and at atmospheric pressure.

In an embodiment, a water vapor transmission rate (WVTR) of the second inorganic encapsulation layer 143 may be about 9*10⁻⁴ g/m²day or less. The second inorganic encapsulation layer 143 can effectively prevent moisture penetration from the outside while having a thin thickness as described above.

In the specification, the WVTR is a numerical value of moisture permeability that represents the amount of water vapor passing through a specific film or layer for unit time in unit area. The WVTR may be measured according to regulations in ASTM F1249. The WVTR may be measured using Mocon's AQUATRAN 2 or AQUATRAN 3 equipment.

The display device 10 may include the color filter layer 150 disposed on the encapsulation layer 140. The color filter layer 150 may include multiple color filters 151 through 153. Each of the color filters 151 through 153 may include a filtering pattern area and a light blocking area. The filtering pattern area may be formed to overlap an emission area EA and may form an output area from which light emitted from the emission area EA may be output. The light blocking area may be an area through which light cannot pass because the color filters 151 through 153 may be stacked on each other.

The color filters 151 through 153 may include a first color filter 151, a second color filter 152, and a third color filter 153 disposed to correspond to different emission areas EA, respectively. Each of the color filters 151 through 153 may include a colorant such as a dye or pigment that absorbs light in wavelength bands other than light in a specific wavelength band and may be disposed to correspond to the color of light emitted from an emission area EA. For example, the first color filter 151 may be a red color filter that transmits only red first light. The second color filter 152 may be a green color filter that transmits only green second light, and the third color filter 153 may be a blue color filter that transmits only blue third light. In FIG. 4, only the filtering pattern area of the second color filter 152 overlaps an emission area EA. However, an emission area of an adjacent subpixel may be overlapped by the filtering pattern area of the first color filter 151 or the filtering pattern area of the third color filter 153.

The display device 10 can reduce the intensity of reflected light caused by external light because the color filters 151 through 153 overlap each other. Furthermore, the color of reflected light caused by external light can be controlled by adjusting the arrangement, shapes, and areas of the color filters 151 through 153 in a plan view.

An overcoat layer OC may be disposed on the color filter layer 150 to planarize the tops of the color filters 151 through 153. The overcoat layer OC may be a colorless light-transmitting layer that does not have a color in a visible light band. For example, the overcoat layer OC may include a colorless light-transmitting organic material such as acrylic resin.

A method of fabricating a display device 10 will now be described with reference to other drawings.

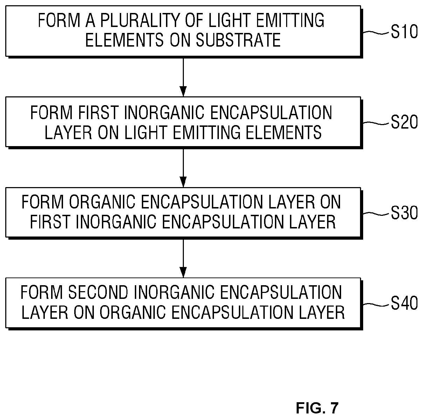

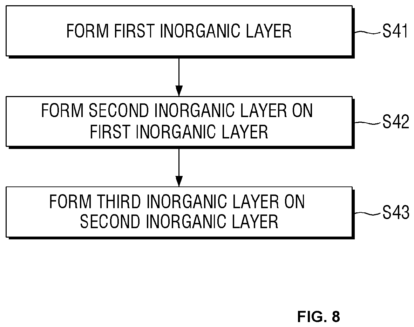

FIG. 7 is a flowchart illustrating a method of fabricating a display device according to an embodiment. FIG. 8 is a flowchart illustrating, in detail, a process of forming a second inorganic encapsulation layer in FIG. 7.

Referring to FIGS. 7 and 8, the method of fabricating the display device 10 according to the embodiment may include forming multiple light emitting elements EL on a substrate (operation S10), forming a first inorganic encapsulation layer 141 on the light emitting elements EL (operation S20), forming an organic encapsulation layer 142 on the first inorganic encapsulation layer 141 (operation S30), and forming a second inorganic encapsulation layer 143 on the organic encapsulation layer 142 (operation S40). The forming of the second inorganic encapsulation layer 143 (operation S40) may include forming a first inorganic layer IL1 (operation S41), forming a second inorganic layer IL2 on the first inorganic layer IL1 (operation S42), and forming a third inorganic layer IL3 on the second inorganic layer IL2 (operation S43). In the display device 10, the second inorganic encapsulation layer 143 may include the inorganic layers IL1 through IL3 formed through different deposition processes.

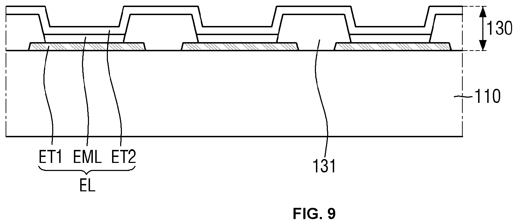

FIGS. 9 through 14 are views sequentially illustrating a process of fabricating a display device according to an embodiment.

Referring to FIG. 9, multiple light emitting elements EL may be formed on a substrate 110 (operation S10) to form a light emitting element layer 130. A pixel defining layer 131 may be formed on the substrate 110, and the light emitting elements EL may be formed in openings of the pixel defining layer 131. The structures of the pixel defining layer 131 and the light emitting elements EL may be the same as those described above. Each of the pixel defining layer 131 and the light emitting elements EL may be formed through a typical patterning process or a deposition process.

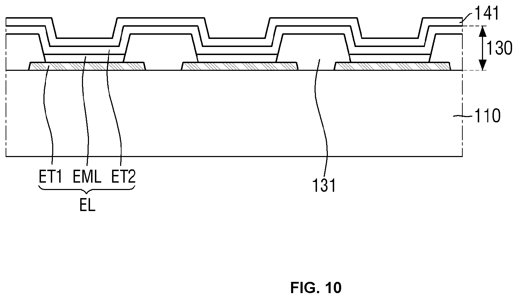

Referring to FIG. 10, a first inorganic encapsulation layer 141 may be formed on the light emitting elements EL (operation S20). The first inorganic encapsulation layer 141 may be composed of one inorganic insulating layer, but the disclosure may not be limited thereto. The first inorganic encapsulation layer 141 may also include multiple inorganic insulating layers.

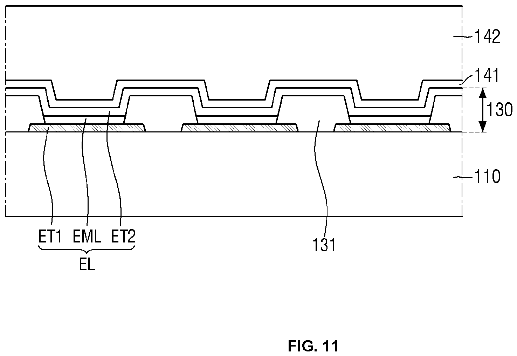

Referring to FIG. 11, an organic encapsulation layer 142 may be formed on the first inorganic encapsulation layer 141 (operation S30). The organic encapsulation layer 142 may include an organic insulating material. The process of forming the organic encapsulation layer 142 may not be particularly limited. For example, the organic encapsulation layer 142 may be formed through a chemical vapor deposition (CVD) method or an inkjet printing process.

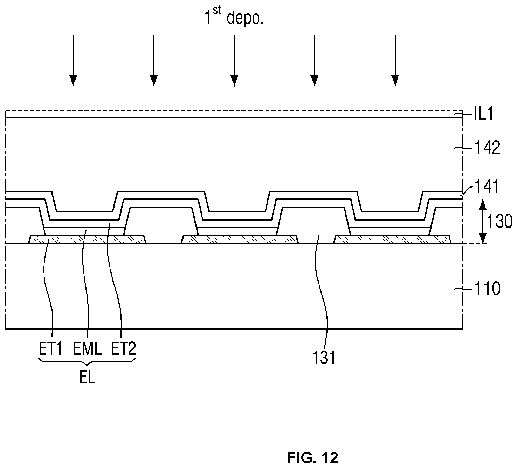

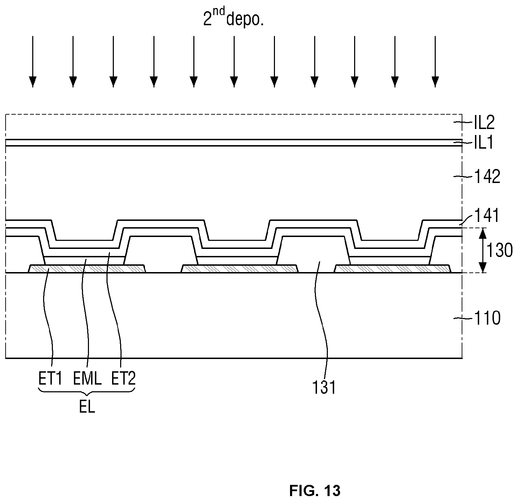

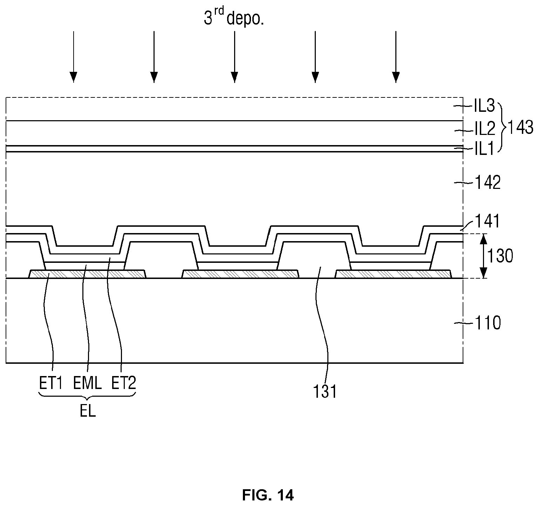

Referring to FIGS. 12 through 14, a second inorganic encapsulation layer 143 may be formed on the organic encapsulation layer 142 (operation S40). The forming of the second inorganic encapsulation layer 143 may include forming a first inorganic layer IL1 illustrated in FIG. 12 (operation S41), forming a second inorganic layer IL2 on the first inorganic layer IL1 illustrated in FIG. 13 (operation S42), and forming a third inorganic layer IL3 on the second inorganic layer IL2 illustrated in FIG. 14 (operation S43).

In an embodiment, the forming of the first inorganic layer IL1 (operation S41) may be performed by a plasma enhanced atomic layer deposition (PEALD) or PECVD process. The forming of the second inorganic layer IL2 (operation S42) and the forming of the third inorganic layer IL3 (operation S43) may be performed by a PECVD process.

In the forming of the first inorganic layer IL1 (operation S41), the first inorganic layer IL1 may be formed at a first deposition rate. In the forming of the second inorganic layer IL2 (operation S42), the second inorganic layer IL2 may be formed at a second deposition rate. In the forming of the third inorganic layer IL3 (operation S43), the third inorganic layer IL3 may be formed at a third deposition rate.

In an embodiment, the second deposition rate may be greater than the first deposition rate and the third deposition rate. The second deposition rate may be about 30 nm/min or more, and the first deposition rate and the third deposition rate may be about 30 nm/min or less. Accordingly, the film density of the inorganic layer IL1 formed in the forming of the first inorganic layer IL1 (operation S41) and the film density of the inorganic layer IL3 formed in the forming of the third inorganic layer IL3 (operation S43) may be greater than the film density of the inorganic layer IL2 formed in the forming of the second inorganic layer IL2 (operation S42). For example, the film density of the inorganic layer IL1 and the film density of the inorganic layer IL3 may each be about 2.00 g/cm³ or more, and the film density of the inorganic layer IL2 may be about 2.00 g/cm³ or less.

The forming of the first inorganic layer IL1 (operation S41) through the forming of the third inorganic layer IL3 (operation S43) may all be performed in the same chamber using the same precursor. In an embodiment, the inorganic layers IL1 through IL3 may include or consist of silicon nitride (SiNₓ), and a precursor used in a deposition process for forming them may be an aminosilane-based compound having a Si-N bond as a core structure. For example, the precursor used in the process of forming the inorganic layers IL1 through IL3 may include at least one of, but not limited to, cyclosilazane, trisilylamine, bis(diethylamino)silane, bis(t-butylamino)silane, tris(dimethylamino)silane, tris(isopropylamino)silane, tetrakis(dimethylamino)silane, tri(isopropyl)cyclotrisilazane, and tetramethyldisilazane.

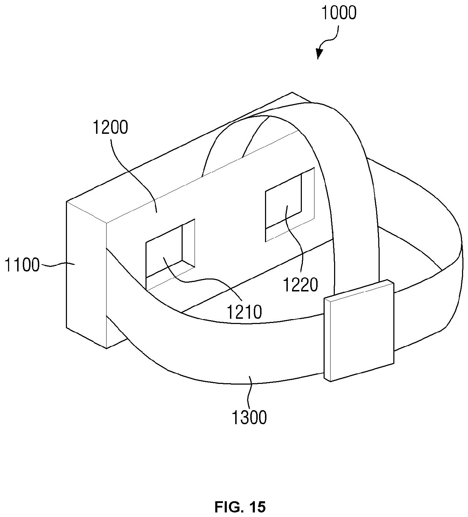

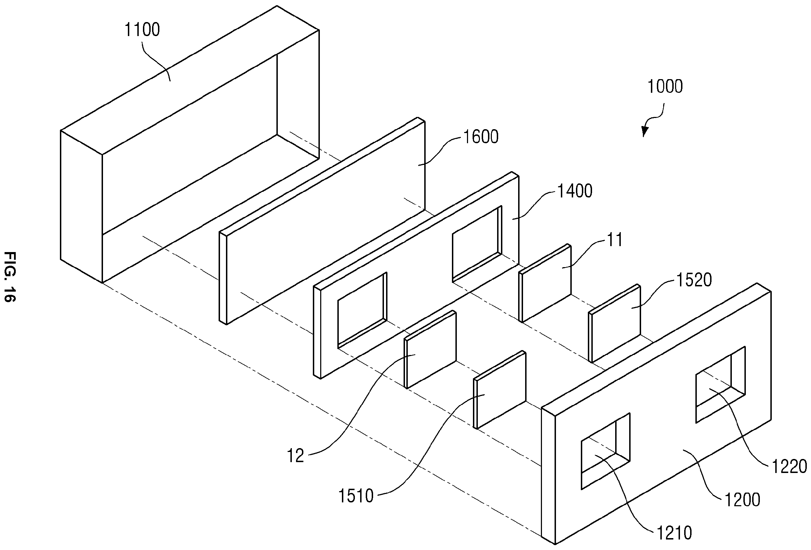

FIG. 15 is a perspective view of a head mounted display device 1000 including an embodiment of the display device according to the present disclosure. FIG. 16 is an exploded perspective view of an example of the head mounted display device 1000 of FIG. 15.

Referring to FIGS. 15 and 16, the head mounted display device 1000 includes a first display device 11, a second display device 12, a display device housing 1100, a housing cover 1200, a first eyepiece 1210, a second eyepiece 1220, a head mounted band 1300, a middle frame 1400, a first optical member 1510, a second optical member 1520, a control circuit board 1600, and a connector. The first display device 11 and the second display device 12 correspond to the display device as described in the embodiments above.

The first display device 11 provides an image to a user's left eye, and the second display device 12 provides an image to the user's right eye. Each of the first display device 11 and the second display device 12 may be substantially the same as the display device 10 described with reference to FIG. 1. Therefore, a description of the first display device 11 and the second display device 12 will be omitted.

The first optical member 1510 may be disposed between the first display device 11 and the first eyepiece 1210. The second optical member 1520 may be disposed between the second display device 12 and the second eyepiece 1220. Each of the first optical member 1510 and the second optical member 1520 may include at least one convex lens.

The middle frame 1400 may be disposed between the first display device 11 and the control circuit board 1600 and may be disposed between the second display device 12 and the control circuit board 1600. The middle frame 1400 may support and fix the first display device 11, the second display device 12, and the control circuit board 1600.

The control circuit board 1600 may be disposed between the middle frame 1400 and the display device housing 1100. The control circuit board 1600 may be electrically connected to the first display device 11 and the second display device 12 through the connector. The control circuit board 1600 may convert an image source received from the outside into digital video data and transmit the digital video data to the first display device 11 and the second display device 12 through the connector.

The control circuit board 1600 may transmit the digital video data corresponding to a left-eye image optimized for a user's left eye to the first display device 11 and transmit the digital video data corresponding to a right-eye image optimized for the user's right eye to the second display device 12. As another example, the control circuit board 1600 may transmit the same digital video data to the first display device 11 and the second display device 12.

The display device housing 1100 houses the first display device 11, the second display device 12, the middle frame 1400, the first optical member 1510, the second optical member 1520, the control circuit board 1600, and the connector. The housing cover 1200 may be placed to cover an open surface of the display device housing 1100. The housing cover 1200 may include the first eyepiece 1210 on which a user's left eye may be placed and the second eyepiece 1220 on which the user's right eye may be placed. Although the first eyepiece 1210 and the second eyepiece 1220 may be disposed separately in FIGS. 15 and 16, the disclosure is not limited thereto. The first eyepiece 1210 and the second eyepiece 1220 may also be combined into one.

The first eyepiece 1210 may be aligned with the first display device 11 and the first optical member 1510, and the second eyepiece 1220 may be aligned with the second display device 12 and the second optical member 1520. Therefore, a user can view an image of the first display device 11, which may be enlarged as a virtual image by the first optical member 1510, through the first eyepiece 1210, and can view an image of the second display device 12, which may be enlarged as a virtual image by the second optical member 1520, through the second eyepiece 1220.

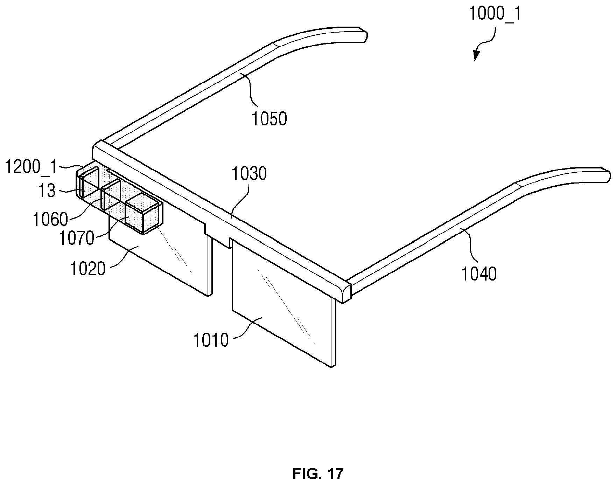

The head mounted band 1300 fixes the display device housing 1100 to a user's head so that the first eyepiece 1210 and the second eyepiece 1220 of the housing cover 1200 may be kept placed on the user's left and right eyes, respectively. In case that the display device housing 1200 is implemented to be lightweight and small, the head mounted display device 1000 may include an eyeglass frame as illustrated in FIG. 17, instead of the head mounted band 1300.

The head mounted display device 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 17 is a perspective view of a head mounted display device 1000_1 according to an embodiment.

Referring to FIG. 17, the head mounted display device 1000_1 according to the embodiment may be a display device in the form of glasses in which a display device housing 1200_1 may be implemented to be lightweight and small. The head mounted display device 1000_1 according to the embodiment may include a display device 13, a left lens 1010, a right lens 1020, a support frame 1030, eyeglass frame legs 1040 and 1050, an optical member 1060, an optical path conversion member 1070, and the display device housing 1200_1.

The display device housing 1200_1 may include the display device 13, the optical member 1060, and the optical path conversion member 1070. An image displayed on the display device 13 may be enlarged by the optical member 1060, may have its optical path converted by the optical path conversion member 1070, and may be provided to a user's right eye through the right lens 1020. Accordingly, the user can view, through the right eye, an augmented reality image into which a virtual image displayed on the display device 13 and a real image viewed through the right lens 1020 may be combined.

Although the display device housing 1200_1 may be disposed at a right end of the support frame 1030 in FIG. 17, the disclosure may not be limited thereto. For example, the display device housing 1200_1 may also be disposed at a left end of the support frame 1030. An image of the display device 13 may be provided to a user's left eye. As another example, the display device housing 1200_1 may be disposed at both the left and right ends of the support frame 1030. The user can view an image displayed on the display device 13 through both the left and right eyes.

In a display device according to an embodiment, an inorganic encapsulation layer of an encapsulation layer can have excellent encapsulation properties while having a thin thickness.

However, the effects of the disclosure may not be restricted to the one set forth herein. The above and other effects of the disclosure will become more apparent to one of daily skill in the art to which the disclosure pertains by referencing the claims.

While the disclosure has been particularly shown and described with reference to embodiments thereof, it will be understood by those of ordinary skill in the art that various changes in form and detail may be made therein without departing from the scope of the disclosure as defined by the following claims. The embodiments should be considered in a descriptive sense only and not for purposes of limitation.

## Claims

1. A display device (10) comprising:
a light emitting element layer (130) disposed on a substrate (110) and comprising a plurality of light emitting elements; and
an encapsulation layer (140) comprising a first inorganic encapsulation layer (141) disposed on the light emitting element layer (130), an organic encapsulation layer (142) disposed on the first inorganic encapsulation layer (141), and a second inorganic encapsulation layer (143) disposed on the organic encapsulation layer (142), wherein
the second inorganic encapsulation layer (143) comprises:
a first inorganic layer (IL1) disposed on the organic encapsulation layer;
a second inorganic layer (IL2) disposed on the first inorganic layer (IL1); and
a third inorganic layer (IL3) disposed on the second inorganic layer (IL2),
a thickness of the second inorganic layer (IL2) is greater than a thickness of the third inorganic layer (IL3),
the thickness of the third inorganic layer (IL3) is greater than a thickness of the first inorganic layer (IL1), and
a refractive index of the second inorganic layer (IL2) is 1.9 or more measured by ellipsometry at a wavelength of 587.56 nm.

2. The display device (10) of claim 1, wherein a refractive index of each of the first inorganic layer, the second inorganic layer, and the third inorganic layer is in a range of 1.90 to 2.10 measured by ellipsometry at a wavelength of 587.56 nm.

3. The display device (10) of claims 1 or 2, wherein
a difference in refractive index between the first inorganic layer and the second inorganic layer is less than or equal to 0.2,
a difference in refractive index between the second inorganic layer and the third inorganic layer is less than or equal to 0.2, and
a difference in refractive index between the third inorganic layer and the first inorganic layer is less than or equal to 0.2,
the refractive indices measured by ellipsometry at a wavelength of 587.56 nm.

4. The display device (10) of claim 1 or 2, wherein the refractive indices of the first inorganic layer, the second inorganic layer, and the third inorganic layer are the same.

5. The display device (10) of one of claims 1 to 4, wherein each of the first inorganic layer, the second inorganic layer, and the third inorganic layer comprises silicon nitride (SiNₓ).

6. The display device of at least of the preceding claims, wherein
a film density of the first inorganic layer is greater than a film density of the second inorganic layer, and
a film density of the third inorganic layer is greater than the film density of the second inorganic layer.

7. The display device (10) of at least one of the preceding claims, wherein the thickness of the second inorganic layer is greater than a sum of the thicknesses of the first inorganic layer and the third inorganic layer.

8. The display device (10) of claim 7, wherein a sum of the thicknesses of the first inorganic layer, the second inorganic layer, and the third inorganic layer is 210 nm or less.

9. The display device (10) of claim 7, wherein
the thickness of the first inorganic layer is in a range of 0.1 nm to 1.5 nm,
the thickness of the second inorganic layer is in a range of 50 nm to 150 nm, and
the thickness of the third inorganic layer is in a range of 50 nm to 100 nm.

10. The display device (10) of at least one of the preceding claims, wherein a water vapor transmission rate of the second inorganic encapsulation layer (143) is 9*10⁻⁴ g/m²day or less measured according to ASTM F1249.

11. The display device (10) of one of the preceding claims, further comprising:
a circuit layer (120) disposed between the substrate (110) and the light emitting element layer and comprising a first semiconductor layer, a first insulating layer (123), a first conductive layer, a second insulating layer (124), a second conductive layer, a third insulating layer (125), a second semiconductor layer, a fourth insulating layer (126), a third conductive layer, a fifth insulating layer (127) and a fourth conductive layer sequentially disposed on the substrate (110).

12. A method of fabricating a display device (10), the method comprising:
forming a light emitting element layer on a substrate (110), the light emitting layer including a plurality of light emitting elements;
forming a first inorganic encapsulation layer (141) on the light emitting element layer;
forming an organic encapsulation layer (142) on the first inorganic encapsulation layer (141); and
forming a second inorganic encapsulation layer (143) on the organic encapsulation layer (142), wherein
the forming of the second inorganic encapsulation layer (143) comprises:
forming a first inorganic layer on the organic encapsulation layer (142) at a first deposition rate;
forming a second inorganic layer on the first inorganic layer at a second deposition rate; and
forming a third inorganic layer on the second inorganic layer at a third deposition rate, and
the second deposition rate is greater than the first deposition rate and the third deposition rate.

13. The method of claim 12, wherein
the second deposition rate is 30 nm/min or more, and
the first deposition rate and the third deposition rate are 30 nm/min or less.

14. The method of one of claims 12 or 13, wherein the forming of the first inorganic layer, the forming of the second inorganic layer, and the forming of the third inorganic layer use the same precursor, and the precursor is selected from at least one of the group comprising cyclosilazane, trisilylamine, bis(diethylamino)silane, bis(t-butylamino)silane, tris(dimethylamino)silane, tris(isopropylamino)silane, tetrakis(dimethylamino)silane, tri(isopropyl)cyclotrisilazane, and tetramethyldisilazane.

15. The method of at least one of claims 12 to 14, wherein
the forming of the first inorganic layer is performed by a plasma enhanced atomic layer deposition or plasma enhanced chemical vapor deposition process, and
the forming of the second inorganic layer and the forming of the third inorganic layer are performed by a plasma enhanced chemical vapor deposition process.
